# FASCICULE DE BREVET EUROPEEN

(11) **EP 1 070 391 B1**
(45) Date de publication et mention de la délivrance du brevet: **08.01.2003**
(21) Numéro de dépôt: 99911887.0
(22) Date de dépôt: 06.04.1999
(51) Int. Cl.: H03K 17/16

(54) **PROCEDE ET DISPOSITIF DE COMMANDE DE LA COMMUTATION DE TRANSISTOR DE PUISSANCE A GRILLE ISOLEE**
VERFAHREN UND VORRICHTUNG ZUM STEUERN EINES LEISTUNGS-SCHALTTRANSISTORS MIT ISOLIERTEM GATE
METHOD AND DEVICE FOR CONTROLLING AN INSULATED GRID POWER TRANSISTOR SWITCHING

(30) Priorité: 06.04.1998 FR 9804251
(43) Date de publication de la demande: 24.01.2001
(73) Titulaire: CENTRE NATIONAL DE LA RECHERCHE SCIENTIFIQUE (CNRS), 75016 Paris (FR)
(72) Inventeur: BAUSIERE, Robert, F-62400 Béthune (FR); FRANCHAUD, Jean-Jacques, F-59260 Hellemmes Lille (FR); IDIR, Nadir, F-59650 Villeneuve d'Asq (FR)
(74) Mandataire: Habasque, Etienne Joel Jean-François
(86) Numéro de dépôt international: FR9900795
(87) Numéro de publication internationale: WO99052212

(56) Documents cités:
- EP-A- 0 542 460
- US-A- 5 633 600

## Description

La présente invention est relative à un procédé de commande de la commutation de transistors de puissance, ainsi qu'à un dispositif pour la mise en oeuvre d'un tel procédé.

Plus particulièrement, l'invention se rapporte à un procédé et à un dispositif de commande de la commutation de transistors de puissance à grille isolée.

Les transistors de puissance à grille isolée présentent l'avantage de pouvoir fournir des courants importants, jusqu'à quelques centaines d'ampères, à partir d'un signal de commande ayant une tension relativement faible, dans la mesure où son rôle est de commuter le courant de charge ou de décharge de la capacité parasite d'entrée des transistors à chaque changement d'état.

Dans l'état de la technique, le signal de commande est constitué par une tension en forme de créneau évoluant entre un niveau bas, sensiblement égal à 0, et un niveau haut de l'ordre de 15 à 20 V.

Dans une cellule élémentaire de commutation commandée en commutation selon cette technique, une préoccupation constante est la limitation du gradient de courant lors de la mise en conduction d'un transistor afin d'éviter l'apparition d'une surintensité due au recouvrement inverse de la diode intégrée à la cellule, dont la fermeture du transistor entraîne le blocage.

Par ailleurs, lors des commutations du transistor, des oscillations du courant et de la tension apparaissent ce qui tend à engendrer des perturbations électromagnétiques néfastes.

Une méthode connue pour limiter le gradient de courant à la mise en conduction consiste à donner une valeur élevée à une résistance intercalée entre un générateur de créneau et l'électrode de commande du transistor, ce qui permet de ralentir la charge de la capacité d'entrée du transistor et la vitesse d'établissement du courant dans le matériau semiconducteur entrant dans la constitution du transistor.

Toutefois, cette résistance provoque un ralentissement de la décharge, ce qui se traduit par une augmentation nuisible de la durée de la phase de retour à l'état bloqué du composant. Cet inconvénient peut être réduit en branchant en parallèle sur la résistance une diode autorisant une décharge rapide de la capacité.

Dans un bras d'onduleur, deux transistors sont branchés en série sous la même tension. Il est donc généralement nécessaire d'introduire des temps morts entre les signaux de commande qui leur sont appliqués pour éviter tout risque de court-circuit de la source de tension, ce qui entraînerait une surintensité fatale pour les interrupteurs simultanément fermés.

Ces temps morts peuvent toutefois être à l'origine de l'ouverture momentanée du circuit de la source de courant et donc d'un gradient de courant élevé et d'une surtension créée par les inductances parasites de la cellule.

Ils réduisent également la fréquence maximale de découpage et la largeur minimale des impulsions dans le c_{GS} d'une commande en modulation par largeur d'impulsion (MLI).

Généralement, les pertes de commutation dans les transistors de puissance peuvent être réduites en utilisant des circuits d'aide à la commutation (CALC) qui placent les interrupteurs dans des conditions telles que, pendant la fermeture, une inductance série ralentit la montée du courant et, pendant l'ouverture, un condensateur branché en parallèle ralentit la montée de la tension après que le courant dans le composant ait chuté.

Toutefois, l'énergie stockée à la fermeture dans l'inductance série doit être évacuée à l'ouverture, ce qui peut être à l'origine d'une surtension aux bornes du transistor. De même, l'énergie stockée à l'ouverture dans le condensateur doit être évacuée à la fermeture, ce qui peut être à l'origine d'une surintensité dans le transistor.

Le but de l'invention est de pallier les inconvénients de l'état de la technique.

Elle a donc pour objet un procédé de commande de la commutation de transistors de puissance par application d'un signal de commande sur la grille du ou de chaque transistor, le signal de commande comportant au moins un palier de tension ayant une valeur intermédiaire entre un premier niveau de tension adapté pour positionner le transistor dans un premier état de commutation et un deuxième niveau de tension adapté pour positionner ce dernier dans un deuxième état de commutation, caractérisé en ce que la valeur intermédiaire de la tension du signal de commande est sensiblement égale à la tension de seuil du transistor, et constitue un moyen de réglage du courant de charge ou de décharge d'une capacité d'entrée du transistor, et en ce que, pour la commande du blocage du transistor, l'on positionne la tension du signal de commande à une ²valeur sensiblement nulle ou négative, puis on élève la tension de ce dernier jusqu'à ladite valeur intermédiaire, et l'on abaisse la tension du signal de commande jusqu'à une valeur sensiblement nulle ou négative.

Le procédé suivant l'invention peut en outre comporter une ou plusieurs des caractéristiques suivantes, prises isolément ou selon toutes les combinaisons techniquement possibles :
- pour la commande de la mise en conduction du transistor, on élève la tension du signal de commande jusqu'à ladite valeur intermédiaire, puis on élève la tension de ce dernier jusqu'au deuxième niveau de tension; et
- la durée du ou de chaque palier constitue un deuxième moyen de réglage du courant de charge ou de décharge de la capacité d'entrée du transistor.

L'invention a également pour objet un dispositif de commande de la commutation de transistors de puissance, pour la mise en oeuvre d'un procédé tel que défini ci-dessus, caractérisé en ce qu'il comporte au moins une source de tension continue associée à un circuit de mise en forme du signal délivré par la source de tension de manière à engendrer au moins un palier de tension ayant une valeur intermédiaire entre un premier niveau de tension délivré par la source pour positionner le transistor dans un premier état de commutation et un deuxième niveau de tension délivré par la source pour positionner le transistor dans un deuxième état de commutation, le ou chaque circuit de mise en forme étant connecté entre la grille et l'électrode de référence du transistor, en vue de la polarisation de la grille, la valeur de la tension du ou de chaque palier étant sensiblement égale à la valeur de la tension de seuil du transistor.

D'autres caractéristiques et avantages ressortiront de la description suivante, donnée uniquement à titre d'exemple, et faite en référence aux dessins annexés sur lesquels :
- la figure 1 est un schéma illustrant un dispositif de commande, suivant l'invention, pour la commutation d'une cellule élémentaire de commutation ;
- la figure 2 illustre la forme du signal de commande appliqué à la cellule de la figure 1 pour la mise en conduction du transistor ;
- la figure 3 montre la forme du signal de commande appliqué à la cellule de la figure 1 pour le blocage du transistor ;
- la figure 4 montre des courbes illustrant la variation du courant et de la tension aux bornes du transistor de la figure 1 lors de sa mise en conduction ;
- la figure 5 montre des courbes illustrant la variation du courant et de la tension aux bornes du transistor de la figure 1 piloté à l'aide de commande classique en forme de créneau ; et
- la figure 6 montre des courbes illustrant la variation du courant et de la tension aux bornes du transistor de la figure 1 lors du blocage de ce dernier, en utilisant respectivement un signal de commande de commutation conforme à l'invention et un signal de commande de type classique.

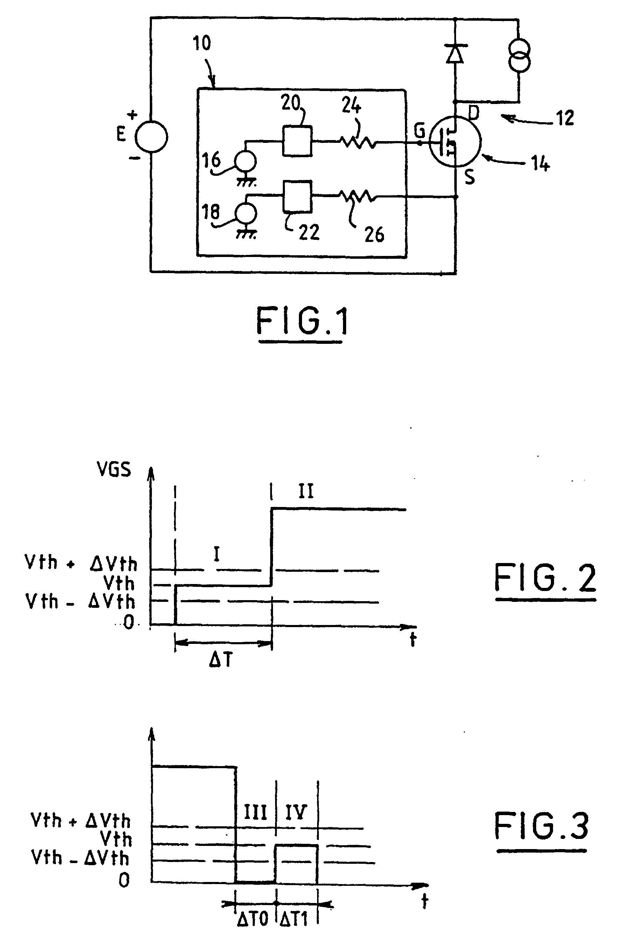

Sur la figure 1, on a représenté un dispositif 10 de commande de la commutation d'une cellule élémentaire de commutation désignée par la référence numérique générale 12.

La cellule 12 est une cellule de type classique. Elle ne sera donc pas décrite en détail par la suite.

On notera toutefois qu'elle comporte un transistor de puissance 14 à grille isolée constitué par un transistor de type MOS.

On conçoit toutefois que l'invention n'est pas limitée à la commande de la commutation d'un tel transistor et s'applique également à la commande de la commutation d'autres types de transistors, par exemple des transistors bipolaires à grille isolée (IGBT).

Le dispositif de commande 10 comporte deux sources de tension continues, respectivement 16 et 18, capables par exemple de délivrer une tension continue de 15 V, associées chacune à un circuit de mise en forme du signal délivré par la source de tension correspondante, désigné par les références numériques 20 et 22.

L'un des circuits de mise en forme, tel que 20, est relié, par l'intermédiaire d'une résistance 24, à la grille du transistor 14, l'autre circuit de mise en forme 22 étant relié, par l'intermédiaire d'une résistance 26, à l'électrode de référence du transistor 14, c'est-à-dire à sa source.

Les circuits de mise en forme des signaux 20 et 22 sont constitués de circuits électroniques appropriés pour l'utilisation envisagée, par exemple de moyens matériels ou de moyens logiciels, c'est-à-dire capables d'effectuer une polarisation de la grille du transistor 14, comme décrit par la suite.

Plus particulièrement, et selon l'invention, pour la commande de la mise en conduction du transistor 14, les circuits de mise en forme 20 et 22 délivrent à la grille G et à la source S du transistor 14 un signal de commande V_{GS} comprenant plusieurs niveaux de tension, selon le type de commutation.

Pour la commande de la mise en conduction du transistor, et comme représenté sur la figure 2, les circuits 20 et 22 élèvent le niveau de tension du signal de commande V_{GS}, initialement nul ou négatif, jusqu'à un palier de tension ayant une valeur intermédiaire entre un premier niveau de tension correspondant au blocage du transistor 14, c'est-à-dire correspondant à une différence de potentiel nulle ou négative entre la grille G et la source S de ce dernier, et un deuxième niveau de tension correspondant à la mise en conduction du transistor 14, c'est-à-dire correspondant à une différence de potentiel entre la grille et la source de ce dernier égale à la tension maximale délivrée par les générateurs 16 et 18.

Ainsi, la mise en conduction du transistor 14 s'effectue, en référence à la figure 2, selon une première phase I d'une durée ΔT réglable au cours de laquelle la tension de commande V_{GS} est positionnée à un niveau de tension Vₜₕ correspondant à la tension de seuil à partir de laquelle des canaux apparaissent dans les couches d'inversion du matériau entrant dans la constitution du transistor 14 et une deuxième phase II au cours de laquelle la tension de commande V_{GS} est fixée à la valeur maximale délivrée par les sources de tension 16 et 18, par exemple égale à 15 V, cette deuxième phase II débutant dès que le courant de charge souhaité pour la capacité d'entrée C_{GS} du transistor est obtenue.

Il est à noter que, comme visible sur la figure 2, et représenté en pointillés, le niveau du palier peut être réglé autour de la valeur de tension de seuil Vₜₕ avec une variation de ± ΔVₜₕ autour de cette valeur de tension de seuil de manière à positionner le signal de commande à une valeur sensiblement inférieure à la tension à laquelle débute l'effet Miller, c'est-à-dire avant l'apparition d'une variation dans la charge de la capacité C_{GS} d'entrée qui aurait pour effet une variation du courant de charge.

Par ailleurs, pour la commande du blocage du transistor 14, et comme représenté sur la figure 3, à partir d'une tension de commande V_{GS} égale par exemple à 15 V, la commande du blocage débute par une première phase III au cours de laquelle la tension V_{GS} est positionnée à une valeur nulle ou négative, suivie d'une phase IV au cours de laquelle la tension du signal de commande est positionnée à un niveau sensiblement égal à la tension Vₜₕ avec une variation égale à ± ΔVₜₕ autour de cette tension de seuil Vₜₕ, comme décrit précédemment.

Après ce palier de tension, le signal de commande est positionné à une valeur sensiblement nulle pour bloquer définitivement le composant.

Il est à noter que, comme pour la commande de la conduction du transistor, il est possible de contrôler la commutation au blocage du transistor, en intervenant sur la durée ΔT₀ de la phase III au cours de laquelle la tension du signal de commande V_{GS} est ramenée à 0 ou à une valeur négative et la durée ΔT₁ du palier IV, ainsi que sur l'amplitude de ce palier.

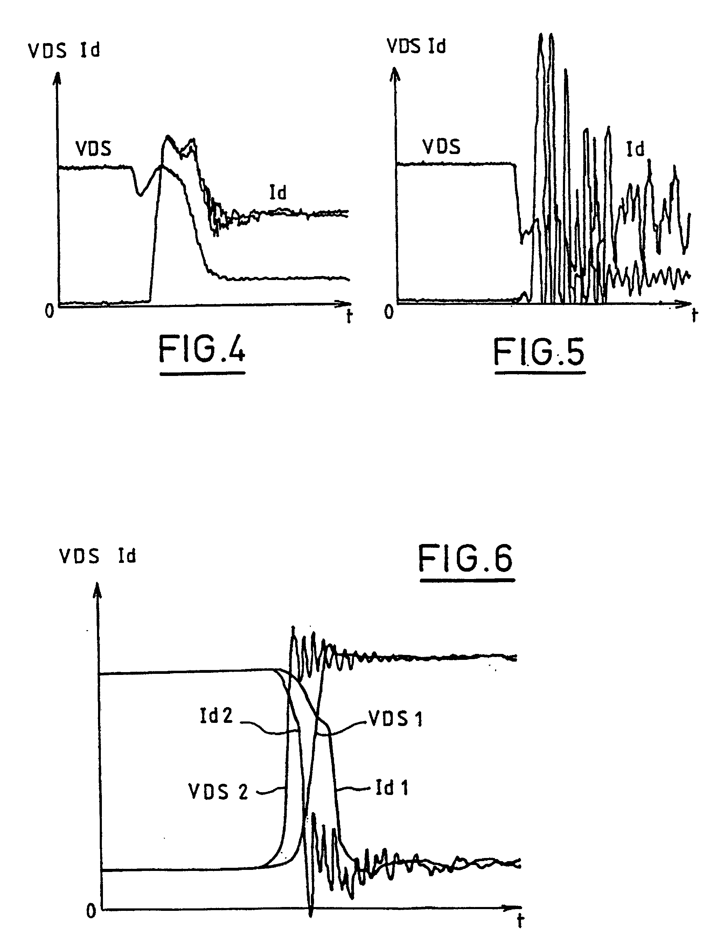

Sur les figures 4 et 5, on à représenté la variation du courant et de la tension aux bornes du transistor 14, lors de sa mise en conduction en appliquant respectivement un signal de commande présentant plusieurs niveaux de tension, conformément au signal représenté sur la figure 3 et un signal de commande en forme de créneau, de type classique, c'est-à-dire un signal présentant un unique niveau à 15 V.

En se référant tout d'abord à la figure 4, on voit que la tension V_{DS} présente entre le drain D et la source S du transistor 14 est sensiblement dépourvue d'oscillation et a généralement la forme d'un créneau, et que le courant I_{d} de drain présente un unique pic dont la valeur s'établit au maximum à 12 A.

Au contraire, et comme représenté sur la figure 5, on voit que la tension V_{DS} comporte une zone transitoire perturbée et que le courant de drain I_{d} comporte de fortes oscillations qui nécessiteraient, pour obtenir un pic de courant sensiblement identique à celui obtenu à l'aide d'un signal de commande conforme à l'invention, de doter le circuit d'une résistance de liaison intercalée entre la source de tension et le transistor ayant une valeur très élevée de l'ordre de 330 Ohms.

On notera en outre que le signal de commande à palier conforme à l'invention permet de réduire considérablement les perturbations électromagnétiques engendrées par le transistor, en raison de la réduction considérable des oscillations.

Sur la figure 6, on a représenté la variation du courant I_{d1} et de la tension V_{ds1} aux bornes du transistor 14 au cours de son blocage, sous l'action d'un signal de commande conforme à l'invention, tel que représenté sur la figure 3, et la variation du courant I_{d2} et de la tension V_{ds2} aux bornes de ce transistor au cours de son blocage sous l'action d'un signal de commande de forme classique, constitué par un créneau de tension.

On voit sur cette figure que la commande du blocage du transistor 14 par palier s'accompagne d'une réduction sensible des oscillations par rapport à une commande de type classique.

En outre, si l'on compare les pentes du courant et de la tension pendant la phase de blocage, le signal de commande conforme à l'invention permet de réduire de façon sensible le gradient de tension et le gradient de courant par rapport à une commande de type classique.

L'invention qui vient d'être décrite a été faite en référence à la commande de la commutation d'une cellule de commutation élémentaire constituée de façon classique par l'association d'un transistor et d'une diode.

Bien entendu, l'invention s'applique également à la commande de la commutation d'un bras onduleur de tension constitué de l'association en série de deux interrupteurs comportant chacun un transistor et une diode montée en antiparallèle.

Comme on le conçoit, la commande de la commutation de chacun de ces transistors permet de commander de façon complémentaire les deux interrupteurs, ce qui n'est pas possible avec une commande classique sans provoquer un court-circuit de la source de tension, comme mentionné précédemment.

On conçoit enfin que l'invention qui vient d'être décrite permet également la commande de la commutation d'interrupteurs de convertisseur matriciel, également connu sous l'appellation convertisseur direct qui utilise des interrupteurs IBTC (Interrupteur bidirectionnel totalement commandable).

## Revendications

1. Procédé de commande de la commutation de transistors (14) de puissance par application d'un signal de commande (V_{GS}) sur la grille du ou de chaque transistor, le signal de commande comportant au moins un palier (I ; IV) de tension ayant une valeur intermédiaire (Vₜₕ ± ΔVₜₕ) entre un premier niveau de tension adapté pour positionner le transistor (14) dans un premier état de commutation et un deuxième niveau de tension adapté pour positionner ce dernier dans un deuxième état de commutation, **caractérisé en ce que** la valeur intermédiaire de la tension du signal de commande est sensiblement égale à la tension de seuil (Vₜₕ ± ΔVₜₕ) du transistor, et constitue un moyen de réglage du courant de charge ou de décharge d'une capacité d'entrée (C_{GS}) du transistor, et **en ce que**, pour la commande du blocage du transistor, l'on positionne la tension du signal de commande (V_{GS}) à une valeur sensiblement nulle ou négative, puis on élève la tension de ce dernier jusqu'à ladite valeur intermédiaire, et l'on abaisse la tension du signal de commande jusqu'à une valeur sensiblement nulle ou négative.

2. Procédé selon la revendication 1, pour la commande de la mise en conduction du transistor, **caractérisé en ce que** l'on élève la tension du signal de commande (V_{GS}) jusqu'à la valeur intermédiaire (Vₜₕ ± ΔVₜₕ), puis on élève la tension de ce dernier jusqu'au deuxième niveau de tension.

3. Procédé selon l'une quelconque des revendications 1 et 2,**caractérisé en ce que** la durée du où de chaque palier (I ; IV) constitue un deuxième moyen de réglage du courant de charge ou de décharge de la capacité d'entrée (C_{GS}) du transistor.

4. Dispositif de commande de la commutation de transistors de puissance (14), pour la misé en oeuvre d'un procédé selon l'une quelconque des revendications 1 à 3, **caractérisé en ce qu'**il comporté au moins une source de tension continue (16, 18) associée à un circuit (20, 22) de mise en forme du signal délivré par la source de tension de manière à engendrer au moins un palier de tension (I ; IV) ayant une valeur intermédiaire (Vₜₕ ± ΔVₜₕ) entre un premier niveau de tension délivré par la source pour positionner le transistor (16) dans un premier état de commutation et un deuxième niveau de tension délivré par la source pour positionner le transistor (14) dans un deuxième état de commutation, le ou chaque circuit (20, 22) de mise en forme étant connecté entre la grille (G) et l'électrode de référence (S) du transistor, en vue de la polarisation de la grille, et **en ce que** la valeur de la tension du ou de chaque palier est sensiblement égale à la valeur de la tension de seuil (Vₜₕ + ΔVₜₕ) du transistor.

## Claims

1. Method of controlling the switching of power transistors (14) by the application of a control signal (V_{GS}) on the grid of the or each transistor, the control signal having at least one voltage level (I; IV) having an intermediate value (Vₜₕ ± ΔVₜₕ) between a first voltage level adapted for positioning the transistor (14) in a first switching state and a second voltage level adapted for positioning the transistor in a second switching state, **characterised in that** the intermediate value of the control signal voltage is substantially equal to the threshold voltage (Vₜₕ ± ΔVₜₕ) of the transistor and constitutes a means for regulating the charging or discharging current of an input capacitance (C_{GS}) of the transistor, and that for controlling the blocking of the transistor the control signal voltage (V_{GS}) is positioned at a value which is substantially zero or negative, then the voltage of this latter is raised to the said intermediate value, and the control signal voltage is lowered to a value which is substantially zero or negative.

2. Method as claimed in Claim 1 for controlling the turning on of the transistor, **characterised in that** the control signal voltage (V_{GS}) is raised to the intermediate value (Vₜₕ ± ΔVₜₕ), then the voltage of the latter is raised to the second voltage level.

3. Method as claimed in any one of Claims 1 and 2, **characterised in that** the duration of the or each level (I; IV) constitutes a second means for regulating the charging or discharging current of the input capacitance (C_{GS}) of the transistor.

4. Device for controlling the switching of power transistors (14) for carrying out a method as claimed in any one of Claims 1 to 3, **characterised in that** it comprises at least one DC voltage source (16, 18) associated with a circuit (20, 22) for shaping the signal supplied by the voltage source in such a way as to generate at least one voltage level (I; IV) having an intermediate value (Vₜₕ ± ΔVₜₕ) between a first voltage level supplied by the source for positioning the transistor (16) in a first switching state and a second voltage level supplied by the source for positioning the transistor (14) in a second switching state, the or each shaping circuit (20, 22) being connected between the grid (G) and the reference electrode (S) of the transistor with a view to polarisation of the grid, and that the value of the voltage of the or each level is substantially equal to the value of the threshold voltage (Vₜₕ ± ΔVₜₕ) of the transistor.

## Patentansprüche

1. Verfahren zur Steuerung des Schaltens von Leistungstransistoren (14) durch Aufgeben eines Steuersignals (V_{GB}) auf das Gate des oder jedes Transistors, wobei das Steuersignal wenigstens eine Spannungsstufe (I; IV) mit einem Zwischenwert (Vₜₕ ± ΔVₜₕ) zwischen einem ersten Spannungsniveau, das zum Setzen des Transistors (14) in einen ersten Schaltzustand eingerichtet ist, und einem zweiten Spannungsniveau, das zum Setzen des Letzteren in einen zweiten Schaltzustand eingerichtet ist, aufweist, **dadurch gekennzeichnet, dass** der Spannungszwischenwert des Steuersignals im Wesentlichen gleich der Schwellenspannung (Vₜₕ ± ΔVₜₕ) des Transistors ist und ein Mittel zur Regulierung des Lade- oder Entladestroms einer Eingangskapazität (C_{GS}) des Transistors bildet, und dass zur Steuerung des Sperrens des Transistors die Spannung des Steuersignals (V_{GS}) auf einen Wert gesetzt wird, der im Wesentlichen null oder negativ ist, dann die Spannung des Letzteren auf den genannten Zwischenwert angehoben wird und die Spannung des Steuersignals bis auf einen Wert, der im Wesentlichen null oder negativ ist, abgesenkt wird.

2. Verfahren nach Anspruch 1, zur Steuerung des Leitendmachens des Transistors, **dadurch gekennzeichnet, dass** die Spannung des Steuersignals (V_{GS}) bis auf den Zwischenwert (Vₜₕ ± ΔVₜₕ) angehoben wird, dann die Spannung des Letzteren bis auf das zweite Spannungsniveau angehoben wird.

3. Verfahren nach irgendeinem der Ansprüche 1 und 2, **dadurch gekennzeichnet, dass** die Dauer der oder jeder Stufe (I; IV) ein zweites Mittel zur Regulierung des Lade- oder Entladestroms der Eingangskapazität (C_{GS}) des Transistors bildet.

4. Vorrichtung zur Steuerung des Schaltens von Leistungstransistoren (14), zur Durchführung eines Verfahrens nach einem der Ansprüche 1 bis 3, **dadurch gekennzeichnet, dass** sie wenigstens eine Gleichspannungsquelle (16, 18) verbunden mit einer Schaltung (20, 22) zur Formung des von der Spannungsquelle gelieferten Signals so, dass wenigstens eine Spannungsstufe (I; IV) mit einem Zwischenwert (Vₜₕ ± ΔVₜₕ) zwischen einem von der Quelle gelieferten ersten Spannungsniveau zum Setzen des Transistors (16) in einen ersten Schaltzustand und einem von der Quelle gelieferten zweiten Spannungsniveau zum Setzen des Transistors (14) in einen zweiten Schaltzustand erzeugt wird, aufweist, wobei die oder jede Formungsschaltung (20, 22) zwischen dem Gate (G) und der Bezugselektrode (S) des Transistors im Hinblick auf die Polarisation des Gate angeschlossen ist, und dass der Spannungswert der oder jeder Stufe im Wesentlichen gleich dem Wert der Schwellenspannung (Vₜₕ ± ΔVₜₕ) des Transistors ist.
